# DEMANDE DE BREVET EUROPEEN

(11) **EP 1 720 391 A2**
(43) Date de publication de la demande: **08.11.2006**
(21) Numéro de dépôt: 06290721.7
(22) Date de dépôt: 04.05.2006
(51) Int. Cl.: H05K 3/44, H05K 1/02

(54) **Circuit imprimé double-face à dissipation thermique**

(30) Priorité: 04.05.2005 FR 0504574; 17.05.2005 FR 0504938
(71) Demandeur: BREE (Beauce Réalisations et Études Électroniques), 45300 Pithiviers (FR)
(72) Inventeur: Barrey, Stéphane, 45530 Vitry aux Loges (FR); Belnoue, Olivier, 45390 Puiseaux (FR)
(74) Mandataire: Breese Derambure Majerowicz

(57) **Abrégé**

La présente invention se rapporte au domaine des circuits imprimés.

La présente invention se rapporte à un procédé de fabrication d'une plaque pour circuit(s) imprimé(s) à dissipation thermique et à double face comprenant une étape de stratification d'au moins un substrat isolant I (4) et d'au moins une couche conductrice C (5) sur un substrat S, caractérisé en ce que :
• ledit substrat S comporte au moins une partie de plaque métallique M (1) de dissipation thermique et au moins une partie de plaque de circuit imprimé CI (2) sensiblement de même épaisseur, l'une des deux au moins une partie étant incrustée dans l'autre au moins une partie,
• ladite stratification est réalisée sur la face dudit substrat S ne comportant pas la face conductrice externe (3) de ladite plaque de circuit CI (2).

## Description

La présente invention se rapporte au domaine des circuits imprimés.

La présente invention concerne plus particulièrement un procédé de fabrication d'un circuit imprimé ou d'une plaque de circuit imprimé à dissipation thermique et à double face. L'invention concerne également le produit associé.

De nombreux composants de circuits intégrés produisent de fortes quantités de chaleur pouvant altérer le circuit imprimé. En particulier, les DEL (diodes électroluminescentes) sont connues pour chauffer intensément au niveau de leur culot. Des solutions ont été proposées, notamment par les demandes de brevet FR 04/51098 et FR 04/51099 du présent demandeur, dans lesquelles un substrat métallique en aluminium est utilisé pour dissiper la chaleur émise par la diode.

Dans certaines réalisations de circuits imprimés simple face à dissipation thermique, par exemple un panneau de diodes dans son caisson, l'accès à la face imprimé du circuit est difficile et les connexions n'en deviennent que plus laborieuses.

Une solution apportée à des fins de gain de place ou d'accessibilité concerne les circuits imprimés doubles faces.

Dans le cas des circuits double face à dissipation thermique, le problème qui se pose concerne le substrat métallique qui, s'il est mal isolé, peut créer des courts-circuits au niveau des connexions traversantes. L'invention s'inscrit dans le cadre des circuits imprimés double face à dissipation thermique pour les composants qui seront intégrés.

L'art antérieur connaît déjà, par la demande de brevet JP 2002 / 353 584, un circuit imprimé double face doté d'un substrat métallique. Dans ce circuit, la base métallique est usinée puis est totalement enrobée par un isolant électrique de type résine. L'ensemble est alors laminé sur les deux faces par un feuillard de cuivre, puis des trous traversants métallisés sont réalisés dans la partie usinée de la base de sorte à connecter les deux faces du circuit. Le problème de cette solution est que le substrat métallique est entièrement recouvert (sur les deux faces) d'un circuit imprimé et, alors, ne joue pas un rôle de dissipateur thermique optimal.

Le document US H1471 présente un circuit similaire. Il s'agit d'un circuit imprimé double face à trous métallisés, réalisé à partir d'une base métallique en cuivre de préférence noyée totalement dans un isolant. Le problème de cette solution est la non utilisation de la base métallique comme dissipateur thermique efficace.

On connaît également, par la demande de brevet espagnol ES 2 177 444, un circuit imprimé double face à base métallique centrale placée entre deux faces de cuivre. La connexion entre les deux faces est réalisée par les pattes de composants intégrés qui traversent de part et d'autre le substrat, l'isolation avec le substrat métallique étant réalisée par un trou traversant de diamètre plus grand. Encore une fois, le substrat métallique n'est pas utilisé de façon optimale pour la dissipation thermique puisqu'il est recouvert sur ses deux faces d'un circuit imprimé.

La présente invention entend remédier aux inconvénients de l'art antérieur en proposant un procédé de fabrication d'un circuit imprimé ou d'une plaque de circuit imprimé à dissipation thermique et à double face permettant, à la fois, d'obtenir une dissipation thermique efficace de composants tels que les diodes électroluminescentes et un circuit à double face locale ce qui assure soit un gain de place soit une facilité de connexion du circuit.

Le procédé selon la présente invention répond particulièrement bien aux attentes futures des utilisateurs de circuits imprimés pour lesquels l'augmentation de puissance et donc de dégagement de chaleur ainsi que le gain de place ou l'accessibilité dorsale d'un circuit encastré sont importantes.

A cet effet, l'invention concerne dans son acception la plus générale un procédé de fabrication d'une plaque pour circuit(s) imprimé(s) à dissipation thermique et à double face comprenant une étape de stratification d'au moins un substrat isolant I et d'au moins une couche conductrice C sur un substrat S, caractérisé en ce que :
- ledit substrat S comporte au moins une partie de plaque métallique M de dissipation thermique et au moins une partie de plaque de circuit imprimé CI sensiblement de même épaisseur, l'une des deux au moins une partie étant incrustée dans l'autre au moins une partie,
- ladite stratification est réalisée sur la face dudit substrat S ne comportant pas la face conductrice externe de ladite plaque de circuit CI.

On entend par « plaque de circuit imprimé » l'ensemble constitué des couches substrat, isolant et cuivre laminées que l'image du circuit imprimé soit réalisée ou non sur le feuillard de cuivre. Dans le cadre de l'invention, le terme « circuit imprimé » implique la présence de l'image du circuit sur le feuillard.

Ainsi, une des faces de la plaque métallique est à nu, assurant une dissipation thermique efficace, d'autant plus qu'elle peut être mise en contact avec un radiateur ou un flux de dissipation thermique (eau, air, ...)

Dans un mode de réalisation, le procédé comprend, en outre, une étape de constitution dudit substrat S consistant à évider ladite plaque métallique et à y incruster ladite au moins une plaque de circuit imprimé dont les dimensions correspondent à l'évidement réalisé.

L'avantage procuré est d'avoir un substrat fortement métallique dans lequel des accès dorsaux (grâce aux parties de circuit imprimé qui seront mises en contact avec l'autre face) sont offerts. On peut ainsi souder des composants encombrants (par exemple des connecteurs) du côté substrat de façon à libérer de la place pour les composants principaux (LED avec l'optique).

Dans une variante, le procédé comprend, en outre, une étape de constitution dudit substrat S consistant à évider ladite plaque de circuit imprimé et à y incruster ladite au moins une plaque métallique dont les dimensions correspondent à l'évidement réalisé.

L'avantage procuré ici est d'offrir, dans un circuit imprimé double face, une dissipation thermique efficace et localisée aux endroits où seront intégrés des composants à fort dégagement de chaleur.

Particulièrement, chacune des zones de contact entre lesdites parties de plaque métallique et de circuit imprimé ne se réduit pas à un segment linéaire.

Cela permet d'assurer une solidité à l'incrustation de l'une des parties dans l'autre. En effet, si le contact entre les deux parties se résumait à un segment linéaire, une force perpendiculaire au plan sur l'une des deux parties viendrait rapidement à bout de la liaison entre elles.

Dans un mode de réalisation particulier, le procédé comprend, en outre, une étape de connexion électrique entre la face externe du circuit CI et la couche conductrice C par perçage mécanique de l'ensemble stratifié et coulage d'une encre conductrice dans ledit perçage. Cela permet d'assurer le contact électrique entre les deux couches du circuit obtenu.

Dans le cas d'un circuit imprimé de type multicouches, ledit procédé comprend, préalablement à ladite étape de coulage d'une encre conductrice, une étape de métallisation du perçage.

Particulièrement, ladite étape d'incrustation est réalisée par pressage à chaud de la partie métallique, de la partie circuit imprimé, du substrat isolant I et de la couche conductrice C. Ce pressage à chaud offre l'avantage de faire fondre partiellement l'isolant I qui vient « souder » les deux parties (plaque métallique et circuit imprimé) entre elles, offrant une plus grande rigidité.

L'invention concerne également une plaque pour circuit(s) imprimé(s) à dissipation thermique et à double face comprenant au moins un substrat isolant I et une couche conductrice C stratifiés sur un substrat S, ledit substrat S étant constitué d'au moins une partie de plaque métallique M de dissipation thermique et d'au moins une partie de plaque de circuit imprimé CI sensiblement de même épaisseur, l'une des deux au moins une partie étant incrustée dans l'autre au moins une partie.

Dans un mode de réalisation, le substrat S est une plaque métallique dans laquelle au moins une plaque de circuit imprimé est incrustée et la zone de contact entre la plaque métallique et chaque plaque de circuit imprimé ne se réduit pas à un segment linéaire.

Dans une variante, le substrat S est un circuit imprimé dans lequel au moins une plaque métallique est incrustée et la zone de contact entre chaque plaque métallique et la plaque de circuit imprimé ne se réduit pas à un segment linéaire.

Eventuellement, la couche conductrice C est mise en contact électrique avec la face externe du au moins un circuit CI par une encre conductrice déposée dans un perçage traversant et par une métallisation dudit perçage si le circuit imprimé est multicouches.

Dans un mode de réalisation particulier, ladite au moins une partie de plaque métallique du substrat est en contact avec un vecteur de dissipation thermique du type radiateur ou fluide.

Eventuellement, ledit substrat isolant comprend une couche de fibre de verre, ce qui assure la rigidité de l'invention.

L'invention concerne également un circuit imprimé à dissipation thermique et à double face comprenant une plaque pour circuit imprimé selon le procédé, sur les faces de laquelle ont été imprimées des pistes.

On comprendra mieux l'invention à l'aide de la description, faite ci-après à titre purement explicatif, d'un mode de réalisation de l'invention, en référence aux figures annexées :
- la figure 1 représente un substrat évidé pour la mise en oeuvre de la présente invention ;
- la figure 2 illustre la structure d'un circuit double face à dissipation thermique selon l'invention ;
- les figures 3 et 4 illustrent la mise en liaison électrique des deux faces du circuit de la figure 2 ;
- la figure 5 représente un exemple de plaque de substrat pour la mise en oeuvre de l'invention ;
- les figures 6 et 8 illustrent deux modes de réalisation de liaison entre le substrat métallique et la partie simple face incrustée applicables dans le cadre de la présente invention ; et
- la figure 7 illustre une disposition de substrat présentant une zone de rupture.

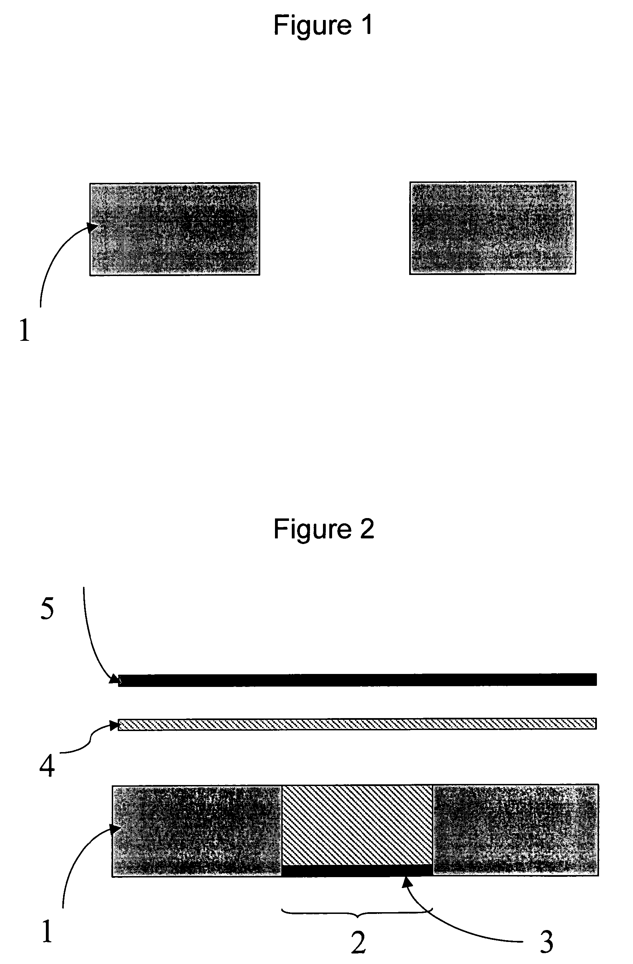

En référence à la figure 1, le substrat du circuit est constitué d'une plaque métallique 1 évidée en partie d'une forme voulue, par évidemment mécanique ou emboutissage par exemple. On choisit cette plaque parmi le cuivre, l'aluminium, un alliage ou équivalent assurant une bonne conductivité thermique. Cette plaque présente une épaisseur d'environ 0,5 mm à quelques millimètres.

En référence maintenant à la figure 2, un circuit imprimé simple face ou multicouches, ou plaque (matériau) de circuit imprimé simple face 2 dont les dimensions et la forme correspondent à celles de l'évidement effectué sur la plaque métallique 1, est incrusté dans l'évidement de la plaque métallique 1. On entend par « incrustation » le fait que le circuit imprimé simple face 2 est inséré dans l'épaisseur donc dans le même plan que la plaque métallique 1, les dimension et forme du circuit étant identiques à l'évidement / ouverture effectuée dans la plaque.

Le circuit imprimé simple face 2 peut également être multicouches et présente une épaisseur sensiblement égale à celle de la plaque métallique 1, à savoir de un à quelques millimètres.

Le circuit imprimé simple face 2 est un matériau d'époxy (FR2, CEM1, CEM3, ...) possédant au moins une face de cuivre 3 à partir de laquelle sera gravé le circuit imprimé.

Il est envisagé de procéder à plusieurs évidements sur la même plaque métallique 1 de sorte à disposer de plusieurs circuits double face localisée à des endroits différents.

Toujours en référence à la figure 2, une couche isolante 4 de type *prepeg* (fibre de verre enrobée de résine ou encre époxy ou Polyimide) puis un feuillard de cuivre 5 sont laminés sur la face du substrat ainsi formé ne comprenant pas la face externe de cuivre 3 du circuit simple face incrusté 2. A titre d'exemple, la résine isolante 4 possède une épaisseur de 100 µm et le feuillard de cuivre 5, une épaisseur de 35 µm.

Eventuellement, plusieurs couches peuvent être laminées sur cette face sans sortir du cadre du brevet afin d'obtenir un circuit multicouches.

Il peut être envisagé d'utiliser un circuit imprimé 2 double face, pour lequel une des deux faces sera recouverte du *prépreg* 4 pour ne constituer plus qu'une couche intermédiaire de la stratification finale. La face non recouverte est la face externe 3 du circuit.

Eventuellement, le dépôt de la résine isolante 4 est effectué de façon sélective (dépôt par méthode soustractive _ c'est-à-dire retrait de la résine là où on n'en souhaite pas_ ou additive _ pas de dépôt à certains endroits_) en laissant libre une partie de la plaque métallique 1. Ceci permet d'optimiser la dissipation thermique du composant qui sera en contact direct avec la plaque métallique 1.

La stratification ainsi constituée (dans l'ordre, substrat incrusté 1 et 2, couche isolante 4 puis feuillard de cuivre 5) est pressée à chaud assurant ainsi un assemblage efficace de la plaque métallique 1 avec le circuit simple face 2. La liaison mécanique (rigidité) de l'ensemble est fournie par la fibre de verre contenu dans la couche isolante 4, la résine qui l'enrobe assurant l'adhésion avec le substrat (parties métallique 1 et circuit 2). Il apparaît de plus, qu'à chaud, un fluage de la résine de la couche isolante 4 dans l'interstice entre la plaque métallique 1 et le circuit imprimé 2 accroît la liaison entre les deux éléments.

La plaque de circuit ainsi obtenue est une plaque de circuit imprimé à dissipation thermique (plaque métallique 1) et à double face localisée (les circuits simple face 2).

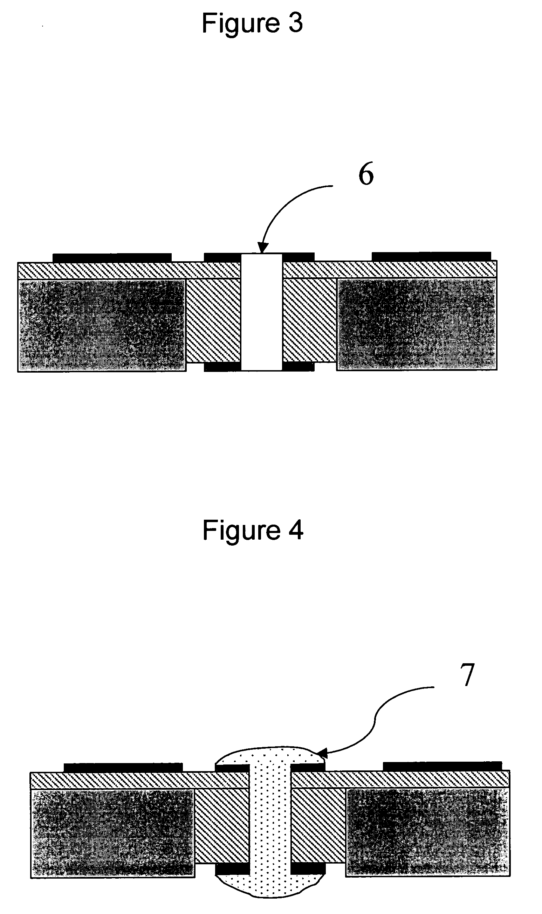

En référence à la figure 3, différents perçages ou évidements mécaniques et électriques 6 sont réalisés ainsi que l'impression des images de circuit sur les deux faces de cuivre extérieures.

Puis, en référence à la figure 4, les deux circuits extérieurs sont mis en contact électrique au moyen d'une encre polymère conductrice argent 7 coulée dans les perçages 6.

Dans le cas d'un circuit imprimé 2 de type multicouches, il est prévu de réaliser une métallisation du perçage avant le dépôt de l'encre polymère conductrice 7 : dépôt de cuivre par voie électrochimique, par exemple. Cette métallisation du perçage assure une bonne liaison électrique des différentes couches intermédiaires du circuit 2. Pour une métallisation par voie électrochimique utilisant des bains de galvanisation, on utilisera, de préférence, une plaque métallique 1 de type cuivre ou alliage comprenant du cuivre.

Le circuit ainsi obtenu permet d'avoir une notion de « double face » locale en un ou différents endroits du circuit final.

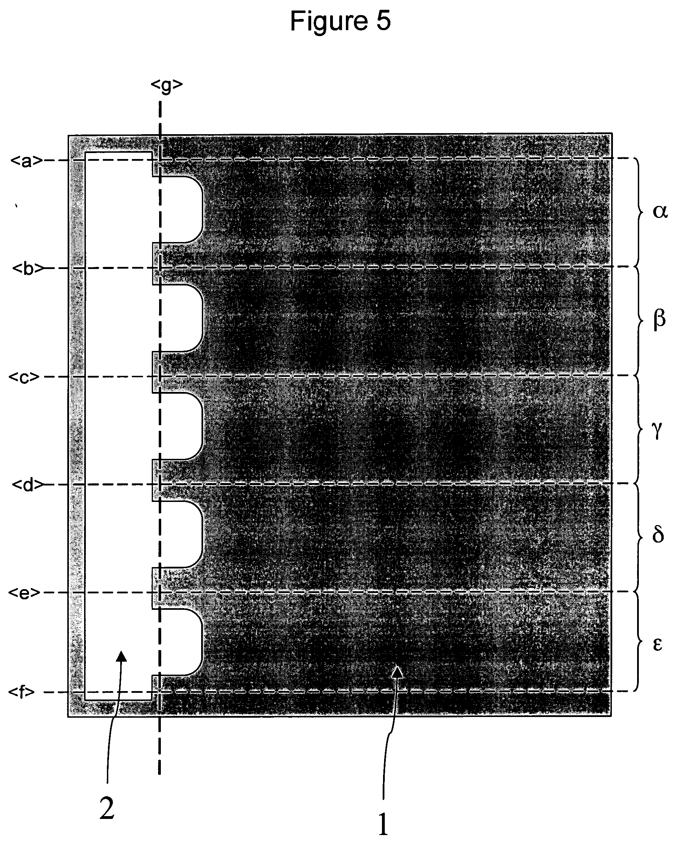

Afin d'optimiser le processus de fabrication, il est envisagé de réaliser l'évidement sur une plaque métallique 1 de grande dimension avec un motif régulier selon le nombre de circuits que l'on souhaite (figure 5). Une fois le procédé précédemment décrit effectué, on réalise un découpage de l'ensemble ainsi réalisé (figure 5 selon les lignes <a> à <g>) pour en obtenir les circuits imprimés à dissipation thermique et à double face désirés (<α> à <ε>).

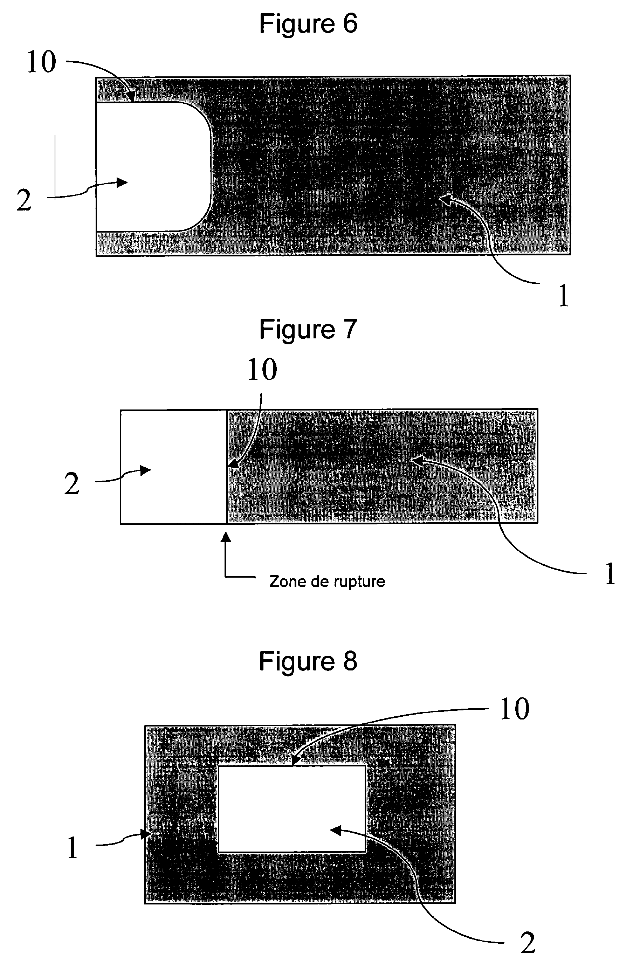

On remarque dans le circuit obtenu (figure 6) que l'incrustation du circuit imprimé simple face 2 dans la plaque métallique 1 n'est pas obligatoirement une incrustation totale, c'est-à-dire que le circuit 2 est entièrement inclus dans la plaque 1. En effet, après découpage, le circuit 2 peut se trouver en bordure de la plaque 1.

Afin d'assurer une solidité d'accroche entre la plaque 1 et le circuit 2 et une rigidité, on évite que le zone de contact 10 entre 1 et 2 se limite à un segment linéaire trop fragile (zone de fragilité, figure 7). On opte alors soit pour une incrustation totale (figure 8), soit par l'ajout de bras de rigidité (figure 6). De façon générale, l'élément incrusté 2 doit être entouré (pas uniquement adjacent) à la plaque 1.

Afin d'optimiser au mieux la dissipation thermique initiée par le substrat métallique, un vecteur de dissipation (par exemple un fluide ou un radiateur) est mis en contact des parties métalliques du substrat pour former un puits thermique efficace.

Dans la description qui précède, il a été choisi de présenter l'invention en partant d'une plaque métallique à laquelle on venait adjoindre des portions de circuit imprimé simple face offrant des accès dorsaux au circuit imprimé principal. L'avantage procuré est l'accessibilité dorsale localisée.

Il est clair que l'invention ne se limite pas à ce mode de réalisation, et que par exemple, il est possible de partir d'un circuit imprimé ou plaque de circuit imprimé simple face dans laquelle on vient adjoindre des portions métalliques aux emplacements où seront intégrés des composants à forte émission de chaleur. L'avantage procuré est la dissipation thermique localisée (parties de la plaque métallique localement incrustées dans le circuit imprimé simple face du substrat).

## Revendications

1. Procédé de fabrication d'une plaque pour circuit(s) imprimé(s) à dissipation thermique et à double face comprenant une étape de stratification d'au moins un substrat isolant I (4) et d'au moins une couche conductrice C (5) sur un substrat S, **caractérisé en ce que** :
• ledit substrat S comporte au moins une partie de plaque métallique M (1) de dissipation thermique et au moins une partie de plaque de circuit imprimé CI (2) sensiblement de même épaisseur, l'une des deux au moins une partie étant incrustée dans l'autre au moins une partie,
• ladite stratification est réalisée sur la face dudit substrat S ne comportant pas la face conductrice externe (3) de ladite plaque de circuit CI (2).

2. Procédé de fabrication selon la revendication 1, **caractérisé en ce qu'**il comprend, en outre, une étape de constitution dudit substrat S consistant à évider ladite plaque métallique (1) et à y incruster ladite au moins une plaque de circuit imprimé (2) dont les dimensions correspondent à l'évidement réalisé.

3. Procédé de fabrication selon la revendication 1, **caractérisé en ce qu'**il comprend, en outre, une étape de constitution dudit substrat S consistant à évider ladite plaque de circuit imprimé (2) et à y incruster ladite au moins une plaque métallique (1) dont les dimensions correspondent à l'évidement réalisé.

4. Procédé de fabrication selon la revendication 1, **caractérisé en ce que** chacune des zones de contact (10) entre lesdites parties de plaque métallique (1) et de circuit imprimé (2) ne se réduit pas à un segment linéaire.

5. Procédé de fabrication selon la revendication 1, **caractérisé en ce qu'**il comprend, en outre, une étape de connexion électrique entre la face externe (3) du circuit CI (2) et la couche conductrice C (5) par perçage (6) mécanique de l'ensemble stratifié et coulage d'une encre conductrice (7) dans ledit perçage.

6. Procédé de fabrication selon la revendication précédente, **caractérisé en ce que** ledit circuit imprimé 2 est multicouches et ledit procédé comprend, préalablement à ladite étape de coulage d'une encre conductrice, une étape de métallisation du perçage.

7. Procédé de fabrication selon la revendication 1, **caractérisé en ce que** ladite étape d'incrustation est réalisée par pressage à chaud de la partie métallique (1), de la partie circuit imprimé (2), du substrat isolant I (4) et de la couche conductrice C (5).

8. Plaque pour circuit(s) imprimé(s) à dissipation thermique et à double face comprenant au moins un substrat isolant I (4) et une couche conductrice C (5) stratifiés sur un substrat S, ledit substrat S étant constitué d'au moins une partie de plaque métallique M (1) de dissipation thermique et d'au moins une partie de plaque de circuit imprimé CI (2) sensiblement de même épaisseur, l'une des deux au moins une partie étant incrustée dans l'autre au moins une partie.

9. Plaque selon la revendication 8, **caractérisé en ce que** le substrat S est une plaque métallique (1) dans laquelle au moins une plaque de circuit imprimé (2) est incrustée et la zone de contact (10) entre la plaque métallique (1) et chaque plaque de circuit imprimé (2) ne se réduit pas à un segment linéaire.

10. Plaque selon la revendication 8, **caractérisé en ce que** le substrat S est un circuit imprimé (2) dans lequel au moins une plaque métallique (1) est incrustée et la zone de contact entre chaque plaque métallique (1) et la plaque de circuit imprimé (2) ne se réduit pas à un segment linéaire.

11. Plaque selon la revendication 8, **caractérisé en ce que** la couche conductrice C (5) est mise en contact électrique avec la face externe (3) du au moins un circuit CI (2) par une encre conductrice (7) déposée dans un perçage traversant (6) et par une métallisation dudit perçage si le circuit imprimé 2 est multicouches.

12. Plaque selon la revendication 8, **caractérisé en ce que** ledit substrat isolant (4) comprend une couche de fibre de verre.
